# EUROPÄISCHE PATENTANMELDUNG

(11) **EP 3 599 807 A1**
(43) Veröffentlichungstag der Anmeldung: **29.01.2020**
(21) Anmeldenummer: 19188083.0
(22) Anmeldetag: 24.07.2019
(51) Int. Cl.: H05K 13/04, H05K 3/22, G05B 19/409

(54) **REWORKSYSTSEM ZUM AUS- UND/ODER EINLÖTEN VON ELEKTRONISCHEN KOMPONENTEN AUF EINER LEITERPLATTE**

(30) Priorität: 26.07.2018 DE 102018118103
(71) Anmelder: Ersa GmbH, 97877 Wertheim (DE)
(72) Erfinder: Hofmann, Udo, 63934 Röllbach (DE); Vuppala, Sai-Krishna, 97877 Wertheim (DE); Sinn, Wolfram, 63071 Offenbach (DE); Schulz, Benedict, 97877 Wertheim-Bettingen (DE)
(74) Vertreter: DREISS Patentanwälte PartG mbB

(57) **Zusammenfassung**

Reworksystem (10) zum Aus- und/oder Einlöten von elektronischen Komponenten auf einer Leiterplatte (14), mit einem Arbeitstisch (12) zur Befestigung der Leiterplatte (14), mit einer in entlang wenigstens einer X-Achse (18) und einer Y-Achse (20) verfahrbaren Modul (16) mit wenigstens einer Kamera (44, 46) zur Aufnahme von auf der Leiterplatte (14) vorgesehenen elektronischen Komponenten, mit einer Antriebseinheit (30) zum Verfahren des Moduls (16) mit der Kamera (44, 46), mit einer Steuereinheit (32) zur Ansteuerung der Antriebseinheit (30), mit einer Recheneinheit (34), der ein Display (36) und von einem Benutzer bedienbaren Eingabemittel (38) zugeordnet sind, wobei die Eingabemittel (38) einen auf dem Display bewegbaren Zeiger (56) und einen Befehlsgeber umfassen, welches in einem Positioniermodus zur Positionierung der Kamera (44, 46) in zwei Schritten (Grobpositionierung und Feinpositionierung) betreibbar ist.

## Beschreibung

Die Erfindung betrifft ein Reworksystem zum Aus- und/oder Einlöten von elektronischen Komponenten auf einer Leiterplatte.

Beim Bestücken von Leiterplatten mit elektronischen Komponenten können fehlende oder schlechte Lötverbindungen auftreten. Zudem können elektronische Komponenten komplett fehlen, falsch platziert, verdreht oder defekt sein. Zur Behebung dieser Fehler finden Reworksysteme Verwendung, mittels denen die einzelnen Komponenten auf der Leiterplatte ausgelötet, ggf. ausgetauscht und wieder eingelötet werden.

Zur Reparatur größerer Leiterplatten können hier Reworksysteme Verwendung finden, die einen Arbeitstisch zur Befestigung der Leiterplatte aufweisen. Ferner ist vorzugsweise wenigstens eine Kamera vorhanden, welche die auf der Leiterplatte vorgesehenen elektronischen Komponenten aufnimmt, welche dann auf einem Display vergrößert dargestellt werden. Die Kamera ist dabei über dem Arbeitstisch entlang wenigstens einer X-Achse und einer Y-Achse, insbesondere parallel zur befestigten Leiterplatte, frei verfahrbar. Ferner ist denkbar, die Kamera hoch entlang einer Z-Achse senkrecht zur Ebene des Arbeitstisches verfahrbar ist.

Zum Verfahren der wenigstens einen Kamera ist eine Antriebseinheit vorgesehen. Zur Ansteuerung der Antriebseinheit findet eine Steuereinheit Verwendung. Ferner ist eine Recheneinheit, beispielsweise in Form eines Computers vorgesehen, der ein Display und vom Benutzer bedienbare Eingabemittel zugeordnet sind. Die Eingabemittel umfassen dabei insbesondere einen auf dem Display bewegbaren Zeiger, beispielsweise einen Mauszeiger, und einen Befehlsgeber, wie beispielsweise einen Schalter oder Taster an einer Computermaus oder einem Touchpad.

Insbesondere bei der Bearbeitung von größeren Leiterplatten, die eine Seitenlänge 50 oder mehr Zentimeter aufweisen können, hat es sich herausgestellt, dass ein Positionieren der Kamera über den zu bearbeitenden elektronischen Komponenten vergleichsweise schwierig ist, da zum einen die Vergrößerung der auf dem Display dargestellten Komponenten sehr groß ist und da außerdem die Positionierung auf den 1/10 bis 1/100 Millimeter genau sein muss. Hinzu kommt, dass dann, wenn sich die Kamera nicht über der Leiterplatte befindet, sondern z.B. über einem Heizelemente, die Orientierung allein über die visuelle Anzeige nicht möglich ist.

Der vorliegenden Erfindung liegt deshalb die Aufgabe zugrunde, ein eingangs beschriebenes Reworksystem bereitzustellen, bei dem die Positionierung der Kamera auf vergleichsweise einfache Art und Weise erfolgt.

Diese Aufgabe wird gelöst durch ein Reworksystem mit den Merkmalen des Patentanspruchs 1. Dabei ist vorgesehen, dass die Recheneinheit derart ausgebildet ist, dass in einem Positioniermodus mit den Eingabemitteln Steuersignale erzeugt werden, in Abhängigkeit derer die Steuereinheit den Antrieb zur Positionierung der Kamera ansteuert. Folglich werden hier die Eingabemittel und die Recheneinheit auch zur Ansteuerung der Antriebseinheit verwendet, wobei die Steuereinheit, die den Antrieb ansteuert, auch einen Teil der Recheneinheit bilden kann.

Die Recheneinheit ist ferner derart ausgebildet, dass im Positioniermodus auf dem Display in einem Kamerabildbereich das aufgenommene und gegebenenfalls von der Recheneinheit ausgewertete, verarbeitete und/oder bearbeitete Kamerabild, das die Leiterplatte und/oder die elektronischen Komponenten der Leiterplatte vergrößert darstellt, und insbesondere neben dem oder auf dem Kamerabildbereich ein den Arbeitstisch und/oder eine am Arbeitstisch befestigte Leiterplatte zeigendes Übersichtsbild gezeigt sind. Das Übersichtsbild kann dabei beispielsweise von einer zusätzlichen Kamera aufgenommen sein, welche den gesamten Arbeitstisch mit der Leiterplatte erfasst. Das Übersichtsbild kann auch ein hinterlegtes Bild oder ein beispielsweise aus CAD Daten der zu bearbeitenden Leiterplatte gewonnenes Bild oder eine den Arbeitstisch und/oder die jeweilige Leiterplatte repräsentierende Karte sein.

Das auf dem Display angezeigte Kamerabild ist vorzugsweise zweidimensional; allerdings ist auch denkbar, dass das von der wenigstens einen Kamera erzeugte Kamerabild dreidimensional dargeboten wird. Für eine dreidimensionale Darbietung ist es vorteilhaft, wenn nicht nur die Daten von einer Kamera, sondern von zwei oder mehrerer Kameras vorliegen und diese entsprechend ausgewertet, verarbeitet und/oder bearbeitet werden. Damit kann ein Positionieren der Kamera, und gegebenenfalls weiterer verfahrbarer Baugruppen, die das Reworksystem umfasst, im Raum erfolgen.

Auf dem Display sind folglich, ggf. neben weiteren Dingen, der das Kamerabild zeigende Kamerabildbereich und unabhängig davon ein den Arbeitstisch oder die Leiterplatte zeigendes Übersichtsbild gezeigt.

Dabei kann der Zeiger in das Übersichtsbild und dort an eine erste Sollposition der Kamera bewegt werden. Das Übersichtsbild, das einen Überblick über den Arbeitstisch bzw. die Leiterplatte bietet, ist folglich eine Orientierungshilfe für den Benutzer, der den Zeiger in dem Übersichtsbild an die Stelle bewegt, an welche sich die Kamera bewegen soll (Sollposition).

Wird dann der Befehlsgeber betätigt, wird die Antriebseinheit derart angesteuert, dass die Kamera in eine der ersten Sollposition entsprechende erste Solllage verfährt, und dass das in dieser Solllage aufgenommene und gegebenenfalls verarbeitete Kamerabild auf dem Display angezeigt wird. Die Kamera verfährt folglich entsprechend der auf dem Übersichtsbild ausgewählten Sollposition in die zugehörige Solllage. Mit Erreichen der Solllage wird dann das Kamerabild in der Solllage auf dem Display gezeigt. Durch Betätigen des Befehlsgebers an der ersten Sollposition des Übersichtsbilds kann folglich eine Grobpositionierung der Kamera erfolgen; die Kamera bewegt sich in den Bereich, den der Benutzer im Übersichtsbild "grob" auswählt.

Nach Erreichen der ersten Solllage der Kamera ist der Zeiger, der in dem auf dem Display angezeigten Kamerabildbereich frei bewegbar ist, und an eine zweite Sollposition im Kamerabild bewegbar. Der Benutzer kann folglich eine zweite Sollposition im angezeigten Kamerabild auswählen, welche er näher betrachten möchte.

Der Benutzer kann aber auch eine zweite Grobpositionierung vornehmen und dazu den Zeiger an eine andere Stelle im Übersichtsbild bewegen und dort den Befehlsgeber betätigen. Die Kamera bewegt sich dann an diese Position.

Betätigt der Benutzer den Befehlsgeber an der zweiten Sollpositon im Kamerabildbereich, so wird die Antriebseinheit derart angesteuert, dass die Kamera in eine der zweiten Sollposition entsprechende zweite Solllage verfährt, und dass das Kamerabild in dieser Solllage in einer spezifischen Position im Kamerabildbereich auf dem Display angezeigt wird. Die spezifische Position kann insbesondere eine mittige oder zentrierte Position sein. Insofern kann auf einfache Art und Weise eine Feinpositionierung der Kamera erreicht werden.

Dabei können die Grobpositionierung und die Feinpositionierung unabhängig voneinander beliebig oft ausgeführt werden.

Durch das erfindungsgemäße Reworksystem kann folglich in lediglich zwei Schritten eine genaue und insbesondere mittige oder zentrierte Positionierung der Kamera über dem Bereich der Leiterplatte erfolgen, die letztlich betrachtet bzw. bearbeitet werden soll. Ferner ist vorteilhaft, dass keine weiteren, zusätzlichen Eingabemittel erforderlich sind, um die Kamera in die gewünschte, zweite Solllage zu verfahren.

Ferner ist vorteilhaft, wenn das Reworksystem, bzw. dessen Recheneinheit so ausgebildet ist, dass aus einem anderen Modus in den Positioniermodus gewechselt werden kann. Da mit dem erfindungsgemäßen Reworksystem nicht nur eine Kamera positioniert werden, sondern auch elektronische Komponenten gezielt erwärmt werden, gezielt von der Leiterplatte entfernt werden und wieder auf die Leiterplatte aufgesetzt werden, kann die Recheneinheit vorteilhafterweise in unterschiedlichen Modi betrieben werden, insbesondere in einem Positioniermodus, in einem Aufwärmmodus, in einem Entnahmemodus und/oder in einem Einsetzmodus.

Ferner ist vorteilhaft, wenn die Recheneinheit im Positioniermodus derart ausgebildet ist, dass das Kamerabild in der ersten und/oder zweiten Solllage im Kamerabildbereich mittig und insbesondere zentriert angezeigt wird. Die spezifische Position im Kamerabildbereich ist dann eine mittige bzw. zentrierte Position. Dadurch kann gewährleistet werden, dass der Benutzer sich ohne weiteres zurechtfindet, und die gewünschte Solllage mittig auf dem Display, bzw. in dem Bereich, in dem der Kamerabild gezeigt wird, findet.

Zudem ist vorteilhaft, wenn die Recheneinheit im Positioniermodus derart ausgebildet ist, dass im Übersichtsbild eine der jeweiligen aktuellen Istlage der Kamera entsprechende Istposition angezeigt wird. Dies ist insbesondere auch dann von Vorteil, wenn die Kamera verfahren wird. Dadurch kann der Benutzer ohne weiteres erkennen, dass zum einen die Kamera verfahren wird, und zum anderen den Überblick bewahren, in welchem Bereich die Kamera sich relativ zur Leiterplatte bzw. zum Arbeitstisch befindet.

Gemäß der Erfindung ist weiterhin denkbar, dass die Recheneinheit im Positioniermodus derart ausgebildet ist, dass beim Verfahren der Kamera das während des Verfahrens aufgenommene Kamerabild auf dem Display angezeigt wird. Auch hierdurch erhält der Benutzer Rückmeldung, dass die Kamera verfahren wird und sieht dabei das von der Kamera aufgenommen, am Display vergrößert angezeigte Bild der Leiterplatte.

Ferner ist denkbar, dass die Recheneinheit im Positioniermodus derart ausgebildet ist, dass dann, wenn während des Verfahrens der Kamera der Zeiger im Kamerabildbereich oder im Übersichtsbild ist und wenn weiter der Befehlsgeber betätigt wird, die Antriebseinheit derart angesteuert wird, dass die Verfahrbewegung gestoppt wird. Hierdurch hat der Benutzer die Möglichkeit die Verfahrbewegung jederzeit durch Betätigen des Befehlsgebers zu stoppen. Dies kann insbesondere dann sinnvoll sein, wenn der Benutzer beim Verfahren der Kamera einen anderen Bereich der Leiterplatte wahrnimmt, den er im Detail betrachten möchte.

Die Recheneinheit ist vorzugsweise im Positioniermodus derart ausgebildet, dass das Größenverhältnis des angezeigten Kamerabilds zum angezeigten Übersichtsbild im Bereich von 40:3 bis 40:1 und weiter im Bereich von 40:2 ist. Dabei ist denkbar, dass der Kamerabildbereich den größten Teil des Displays einnimmt und dass das Übersichtsbild lediglich um etwa das 20-fache kleiner als der Kamerabildbereich im Bereich des Displays dargestellt wird.

Weiter ist vorteilhaft, wenn die Recheneinheit im Positioniermodus derart ausgebildet ist, dass eine Zoomfunktion des Kamerabilds zur Verfügung gestellt wird und dass die Zoomfunktion mittels dem Zeiger und/oder durch Betätigung des Befehlsgebers betätigbar ist. Die Zoomfunktion kann auf dem Display dargestellt werden, beispielsweise in oder neben dem Kamerabildbereich und/oder in oder neben dem Übersichtsbild.

Ferner hat sich als vorteilhaft herausgestellt, wenn die Recheneinheit im Positioniermodus derart ausgebildet ist, dass der Zeiger, wenn er sich im Bereich des Übersichtsbilds befindet, eine andere Kontur aufweist, als wenn der Zeiger sich im Kamerabildbereich befindet. Hierdurch kann dem Benutzer visualisiert werden, dass dem Zeiger im Kamerabildbereich eine andere Funktion zugeordnet wird als in dem Übersichtsbild. Dabei kann vorteilhafterweise vorgesehen sein, dass die Recheneinheit so ausgebildet ist, dass die Kontur des Zeiger vom Benutzer auswählbar ist. Insbesondere kann ausgewählt werden, welche Kontur in welchem Bereich auf dem Display in der jeweiligen Phase angezeigt wird.

Insbesondere hat sich als vorteilhaft herausgestellt, wenn die Kontur des Zeigers in dem Übersichtsbild als Rechteck dargeboten wird. Die Größe des Rechtecks ist dabei insbesondere proportional zur Größe des von der Kamera gelieferten Kamerabildes. Bei einer großen Vergrößerung durch die Kamera ist folglich das Rechteck im Übersichtsbild vergleichsweise klein; bei einer geringen Vergrößerung ist das Rechteck vergleichweise groß.

Ferner ist denkbar, dass das Übersichtsbild in Planquadrate eingeteilt ist. Der Benutzer kann vergleichsweise schnell mit dem Rechteck-Zeiger eine Position innerhalb den Planquadraten, zwischen den Planquadraten oder auch ein Planquadrat auswählen und den Befehlsgeber betätigen, so dass die Kamera in die erste Solllage verfahren wird.

Die Einteilung der Planquadrate kann dabei einer Anordnung von auf dem Arbeitstisch vorgesehenen Heizelementen entsprechen.

Zur weiteren Steigerung der Funktionalität ist vorteilhaft, wenn die Recheneinheit im Positioniermodus derart ausgebildet ist, dass das Übersichtsbild mittels dem Zeiger und/oder durch Betätigung des Befehlsgebers auf dem Display verschiebbar und/oder minimierbar und/oder maximierbar ist. Das Übersichtsbild kann folglich auf dem Display insbesondere frei bewegt werden und dort hin verschoben werden, wo es die Wahrnehmung des Displays durch den Benutzer nicht stört. Insbesondere ist denkbar, dass das Übersichtsbild in eine der Ecken des Bildschirms verschiebbar ist. Zudem kann insbesondere vorgesehen sein, dass das Übersichtsbild auch transparent oder teiltransparent auf dem Display dargestellt wird.

Weiterhin ist vorteilhaft, wenn die Rechnereinheit derart ausgebildet ist, dass sie ein erstes Modul ausbildet, das das Übersichtsbild auf dem Display darstellt und dass sie ein zweites Modul ausbildet, das den Kamerabildbereich auf dem Display darstellt, wobei beide Module unabhängig voneinander bereitstellbar oder bereitgestellt werden können. Dadurch, dass die beiden Module unabhängig sind, wird die Sicherheit des Reworksystems im Positioniermodus erhöht. Ein Ausfallen oder ein in einem Modul vorhandener Fehler wirkt sich damit nicht unmittelbar auf das andere Modul aus. Die Kommunikation zwischen den beiden Modulen kann durch die Recheneinheit bereitgestellt werden.

Weitere Einzelheiten und vorteilhafte Ausgestaltungen der Erfindung sind der nachfolgenden Beschreibung zu entnehmen, anhand derer ein Ausführungsbeispiel der Erfindung näher beschrieben und erläutert ist.

Es zeigen:
- Figur 1: ein erfindungsgemäßes Reworksystem;
- Figur 2: das Display des Reworksystems gemäß Figur 1 im Positioniermodus in einem ersten Zustand;
- Figur 3: die in der Figur 2 gezeigte Karte in vergrößerter Darstellung;
- Figur 4: das Display gemäß Figur 2 in einem weiteren Zustand;
- Figur 5: das Display gemäß Figur 4 bei der Auswahl der Sollposition;
- Figur 6: das Display gemäß Figur 5 bei Betätigen der Sollposition;
- Figur 7: das Display gemäß Figur 6 beim Verfahren der Kamera;
- Figur 8: das Display gemäß Figur 7 bei Erreichen der Solllage der Kamera;
- Figur 9: das Display gemäß Figur 8 beim Bewegen des Zeigers;
- Figur 10: das Display gemäß Figur 9 beim Bewegen des Zeigers auf die zweite Sollposition, und
- Figur 11: das Display gemäß Figur 10 der zweiten Solllage;

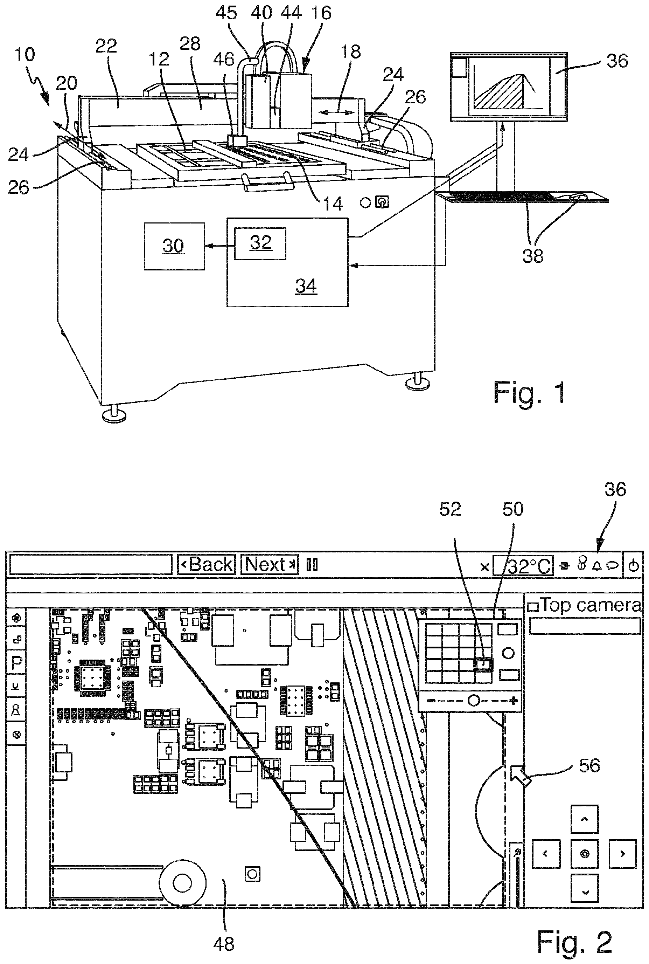

In der Figur 1 ist ein Reworksystem 10 zum Aus- und/oder Einlöten von elektronischen Komponenten auf einer Leiterplatte 14 gezeigt. Das Reworksystem 10 umfasst einen Arbeitstisch 12, auf dem eine Leiterplatte 14 eingespannt ist. Oberhalb des Tisches 12 bzw. der Leiterplatte 14 ist ein Bearbeitungsmodul 16 angeordnet, welches entlang einer X-Achse 18 und einer Y-Achse 20 verfahrbar ist. Das Modul 16 kann auch entlang einer Z-Achse in vertikaler Richtung verfahren werden. Zum Verfahren des Moduls 16 ist ein portalartig ausgebildeter Träger 22 vorgesehen, der an seinen freien Enden zwei Stützen 24 aufweist. Die Stützen 24 können dabei entlang der Y-Achse 20 in zugehörigen Führungen 26 verfahren werden. Am Träger 22 ist eine weitere Führung 28 vorgesehen, entlang derer das Modul in X-Richtung 18, also senkrecht zur Y-Richtung 20 verfahrbar ist. Zum Verfahren des Moduls 16 im Raum ist eine in der Figur 1 nicht näher bezeichnete Antriebseinheit 30 vorgesehen. Die Antriebseinheit 30 kann dabei Servomotoren umfassen, die den Träger 22, und damit das Modul 16 in X-Richtung, das Modul 16 auf den Träger 22 in Y-Richtung und das Modul 16 in vertikaler Z-Richtung verfahren. Zur Ansteuerung der Antriebseinheit 30 ist eine Steuereinheit 32 vorgesehen. Ferner ist eine Recheneinheit 34 vorgesehen, wobei die Steuereinheit 32 Bestandteil der Recheneinheit 34 ist bzw. von dieser gebildet oder in diese integriert ist. Bei einer nicht gezeigten Ausführungsform kann die Steuereinheit auch eine separate, von der Recheneinheit 34 getrennte Einheit bilden.

Der Recheneinheit 34 ist ein Display 36 zugeordnet, sowie von einem Benutzer bedienbare Eingabemittel 38, die bei der gezeigten Ausführungsform eine Tastatur und eine Computermaus mit einem Mauszeiger auf dem Display 36 beinhalten. Das Eingabemittel 38 kann auch anders ausgestaltet sein, beispielsweise als Touchpad oder berührungssensitives Display (Touchscreen).

Das Modul 16 umfasst bei der gezeigten Ausführungsform ein Heizgerät 40, um auf der Leiterplatte 14 vorhandene elektronische Komponenten, bzw. deren Lötverbindungen zur Leiterplatte zu erwärmen. Das Modul 16 umfasst auch ein automatisiertes Greifgerät 42, mit dem elektronische Komponenten von der Leiterplatte 14 abgehoben und positionsgenau auf die Leiterplatte 14 aufgesetzt werden können. Ferner ist im Modul 16 eine Oben-Kamera 44 (im Folgenden als Kamera bezeichnet) verbaut, mit der die Leiterplatte 14, bzw. die darauf angeordneten Komponenten von oben aufgenommen werden. Zusätzlich zur Kamera 44 ist am Modul 16 über einen Arm 45 eine RPC Kamera 46 (Reflow Process Camera) vorgesehen, mit der die elektronischen Komponenten von schräg vorne aufgenommen und insbesondere das Aufschmelzen des Lotes beobachtet werden kann.

Über die Recheneinheit 34, bzw. über zusätzliche Steuereinheiten, kann das Heizgerät 40, das Greifgerät 42 sowie die Kamera 44 und die Zusatzkamera 46 angesteuert werden.

Zum Positionieren des Moduls 16 über der Leiterplatte 14 wird das Modul 16 mit der Kamera 44 über eine geeignete Ansteuerung der Antriebseinheit 30 so verfahren, dass sich das jeweilige elektronische Bauteil auf der Leiterplatte 14 positionsgenau unterhalb dem Modul 16 befindet. Bei größeren Leiterplatten, die eine Länge und eine Breite von mehreren 10-Zentimetern aufweisen können, ist dies nicht ohne weiteres möglich, da zudem das von der Kamera 44 erfasste Bild am Display 36 stark vergrößert gezeigt wird.

Zur Positionierung des Moduls 16 bzw. der Kamera 44 über dem gewünschten Bauteil wird die Rechnereinheit 34 über die Eingabemittel 38 zunächst in einen Positioniermodus geschalten.

In diesem Positioniermodus zeigt das Display 36 das in Figur 2 gezeigte Bild. Auf dem Display 36 ist zum einen in einem Kamerabildbereich 48 das Kamerabild der Kamera 44 gezeigt. In dem Kamerabildbereich 48 ist die Leiterplatte 14 stark vergrößert mit den darauf angeordneten elektronischen Komponenten zu sehen.

Das auf dem Display 36 angezeigte Kamerabild ist vorzugsweise zweidimensional; allerdings ist auch denkbar, dass die von den beiden Kameras 44 und 46 aufgenommenen Bilder von der Recheneinheit 34 derart ausgewertet, verarbeitet und bearbeitet werden, dass ein dreidimensionales Kamerabild im Kamerabildbereich 48 dargeboten wird. Damit kann ein Positionieren der Kamera 44 und des gesamten Moduls 16 mit den zugehörigen Komponenten im Raum oberhalb der Leiterplatte 14 erfolgen. Wenn im weiteren davon die Rede ist, dass das "aufgenommene" Kamerabild im Kamerabildbereich 48 "gezeigt" wird, umfasste dies gegebenenfalls auch das Auswerten, Verarbeiten und Bearbeiten der Bilddaten, die von der Kamera 44 und gegebenenfalls auch der Kamera 46 erzeugt und der Recheneinheit 34 zur Verfügung gestellt werden.

Rechts oben zeigt das Display 36 ein Übersichtsbild in Form einer Karte 50, die die Fläche des Arbeitstisches 12 verkleinert repräsentiert. Die Karte wurde dabei aus einer Illustration von hinterlegten, die Leiterplatte definierenden CAD-Daten erzeugt. Anstelle einer Karte 50 wäre es auch denkbar, ein Kamerabild als Übersichtsbild einzublenden, welches von einer Kamera aufgenommen wird, die den gesamten Arbeitstisch bzw. die gesamte zu bearbeitende Leiterplatte 14 erfasst.

In der Karte 50 ist der Arbeitstisch 12 in 20 Planquadrate unterteilt gezeigt. Je nach Größe und Ausbildung des Arbeitstisches 12 kann auch eine andere Anzahl und Einteilung von Planquadraten vorgesehen sein, insbesondere 5 x 5 Planquadrate, also in Summe 25 Planquadrate. Die Größe und Ausrichtung der Planquadrate kann dabei im Arbeitsraum vorhandenen Heizelementen entsprechen, mit denen die Leiterplatte 14 erwärmt werden kann.

Ferner ist die Ist-Position der Kamera 44 auf der Karte 50 durch Hervorhebung eines Rechtsecks 52 markiert. Der von der Kamera 44 gezeigte Ausschnitt muss dabei nicht unbedingt der Größe eines Planquadrats entsprechen.

Insgesamt hat der Benutzer bei Ansicht der Karte 50 einen unmittelbaren Eindruck, welcher Bereich der Leiterplatte 14 im Kamerabildbereich 48 auf dem Display 36 zu sehen ist.

Auf dem Display 36 gemäß Figur 2 können noch weiteren Informationen zur Verfügung gestellt werden, wie beispielsweise verschiedene Menüs, die zur Änderung des Modi auswählbar sind, sowie weitere technische Informationen.

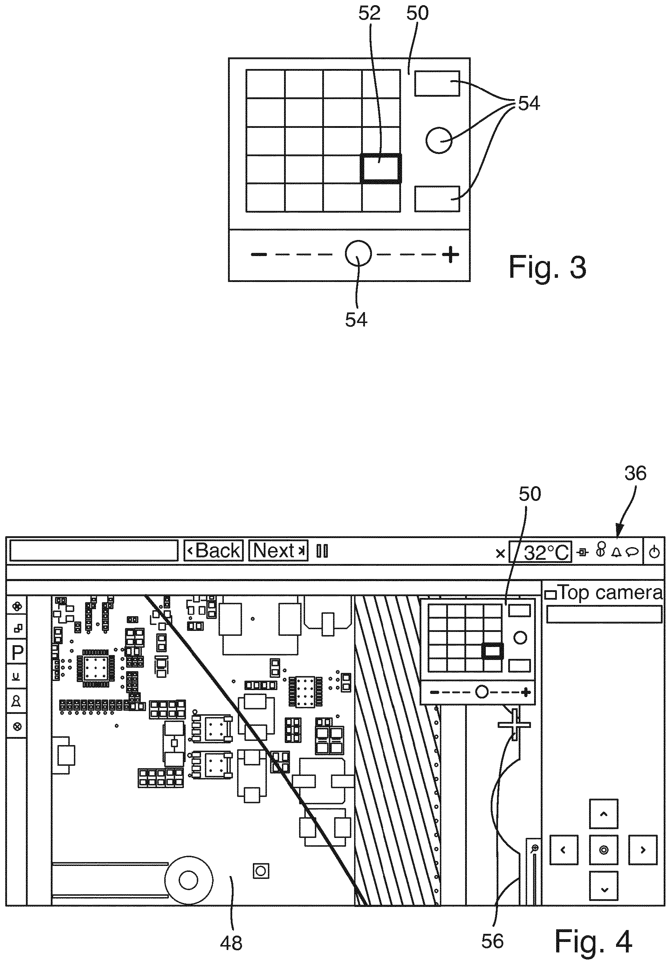

Die Karte 50 ist in Figur 3 vergrößert gezeigt. Deutlich zu erkennen sind einzelne Planquadrate, in welche der Tisch 12 aufgeteilt ist sowie der Bereich bzw. das Rechteck 52 des Tisches 12 bzw. der Leiterplatte 14, welcher bzw. welches derzeit von der Kamera 44 aufgenommen wird. Der hervorgehobene Bereich 52 entspricht folglich der Ist-Position der Kamera 44. Die Karte 50 kann noch weitere Schaltflächen 54 aufweisen, beispielsweise um die Karte 50 zu minimieren oder um die Karte 50 zu maximieren, oder um in die Karte 50 zu zoomen oder um die Karte 50 transparent zu machen.

Um nun im Positioniermodus das Modul 16 und die Kamera 44 in eine bestimmte Position auf vergleichsweise einfache und dennoch positionsgenaue Art und Weise zu verfahren, ist die Rechnereinheit 34 so ausgebildet, dass sie wie nachfolgend erläutert betrieben werden kann.

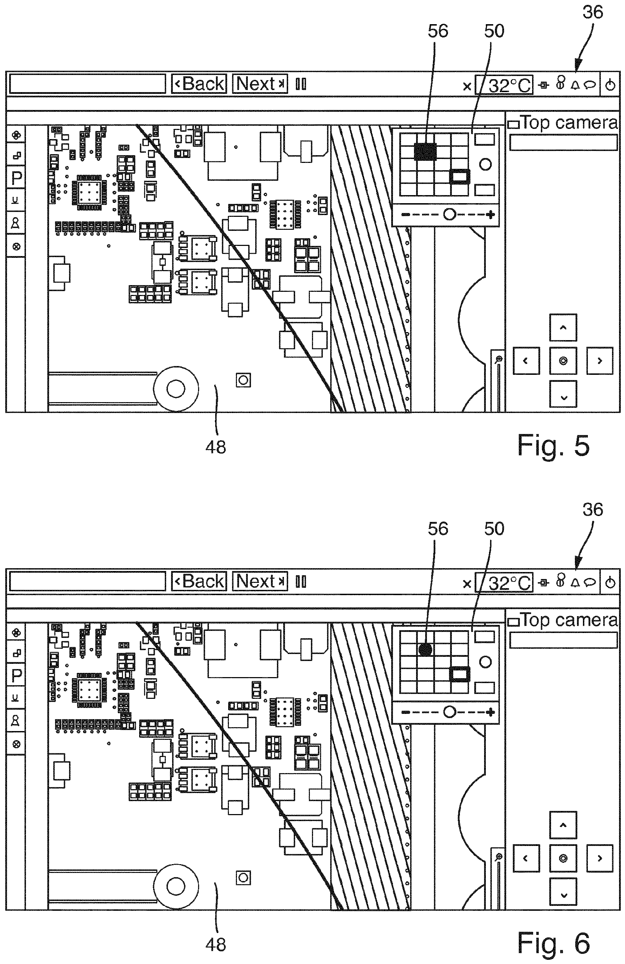

Mittels der Eingabemittel 38, und insbesondere mit einer Maus, kann auf dem Display 36 ein in Figur 2 gezeigter Zeiger 56 bewegt werden. Die Recheneinheit 34 ist dabei so eingerichtet, dass dann, wenn der Zeiger 56 in den oder aus dem Kamerabildbereich 48 bewegt wird, der Zeiger 56 seine Kontur ändert. In der Figur 4 befindet sich der Zeiger 56 innerhalb des Kamerabildbereichs 48 und ist dort als Kreuz dargestellt. Wird der Zeiger 56 nun weiter in den Bereich der Karte 50, wie in Figur 5 dargestellt ist, bewegt, dann ändert der Zeiger 56 wiederum seine Kontur. In Figur 5 ist der Zeiger 56 als ausgefülltes Rechteck dargestellt, welches im Verhältnis der Größe des im Kamerabildbereich 48 anzuzeigenden Kamerabildes entspricht.

Die Recheneinheit 34 ist im Positioniermodus weiter so ausgebildet, dass mit dem Zeiger 56 auf der Karte 50 eine Sollposition ausgewählt werden kann, welche die Kamera 44 anfahren soll. Ein Auswählen der Sollposition erfolgt durch Betätigen eines Befehlgebers am Eingabemittel 28, beispielsweise durch Einfach- oder Doppelklicken der Maustaste.

Wird nun in Figur 5 die mit dem Zeiger 56 ausgewählte Position in der Karte 50 durch Anklicken bestätigt, dann ändert der Zeiger 56 wiederum seine Kontur, wie es in Figur 6 gezeigt ist. Dort ist der Zeiger 56 nach der Auswahl der Sollposition und nach Betätigen des Befehlgebers als Kreis dargestellt.

Die Start- und die Zielposition der Kamera 44 werden also als Rechteck in der Karte 50 dargestellt, wobei die Zielposition durch die Position des Zeigers 56 repräsentiert wird. Nach Auslösen der Fahrt der Kamera 44 wechselt die Form des Zeigers in einen vorzugsweise roten Kreis, in dem vorzugsweise ein weißes Quadrat vorhanden ist. Dieses der Stopp-Taste eines Aufnahmegerätes nachempfundene Symbol soll darauf hinzuweisen, dass eine weitere Befehlseingabe, also ein Klick, während dem Verfahren die Fahrbewegung abbricht. Während dieser insbesondere rote Kreis mit dem weißen Quadrat angezeigt wird, ist keine andere Befehlseingabe möglich, als die Fahrbewegung abzubrechen. Dadurch wird ein Schutzmechanismus bereitgestellt, der dem Benutzer die Suche nach einem Abschaltknopf erspart.

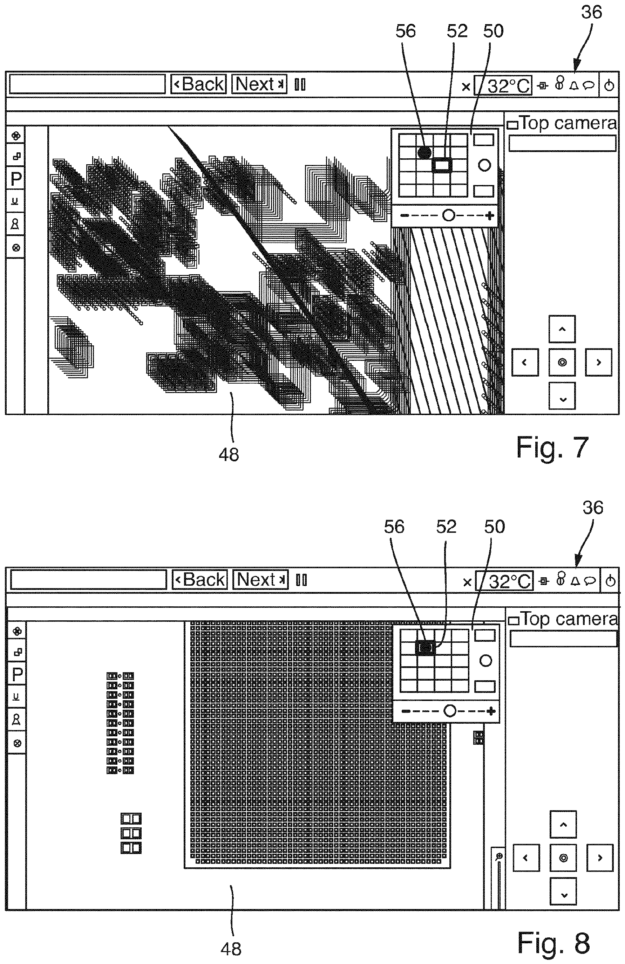

Mit Betätigen des Befehlsgebers wird die Antriebseinheit 30 von der Steuereinheit 32, bzw. von der Recheneinheit 34 so angesteuert, dass das Modul 16, und damit die Kamera 44 in Richtung einer der Sollposition entsprechenden tatsächlichen Solllage zur Grobpositionierung verfahren wird. Während des Verfahrens wird der von der Kamera 44 aufgenommen Kamerabild im Kamerabildbereich 48 des Displays 36 angezeigt, welches aufgrund des vergleichsweise schnellen Verfahrens der Kamera 44 in Figur 7 unscharf bzw. verschwommen ist.

Aufgrund des Bewegens der Kamera 44 ändert sich auch die auf der Karte 50 angezeigte Ist-Position 52 der Kamera 44. Dadurch erhält der Benutzer auch beim Bewegen der Kamera 44 den Überblick, wo sich die Kamera 44 auf der Karte 50 befindet bzw. welcher Abschnitt der Leiterplatte 14 im Kamerabildbereich 48 wiedergegeben wird.

Mit Erreichen der Solllage der Kamera 44 erreicht die auf der Karte 50 dargestellte Ist-Position 52 die in der Karte 50 ausgewählte Sollposition; in Figur 8 umgibt das umrandeten Rechteck, also die Ist-Position 52 die ausgewählte erste Sollposition, die vom Zeiger 56 angeklickt wurde. In dem Kamerabildbereich 48 wird nun der zugehörige Ausschnitt der Leiterplatte 14 dargestellt.

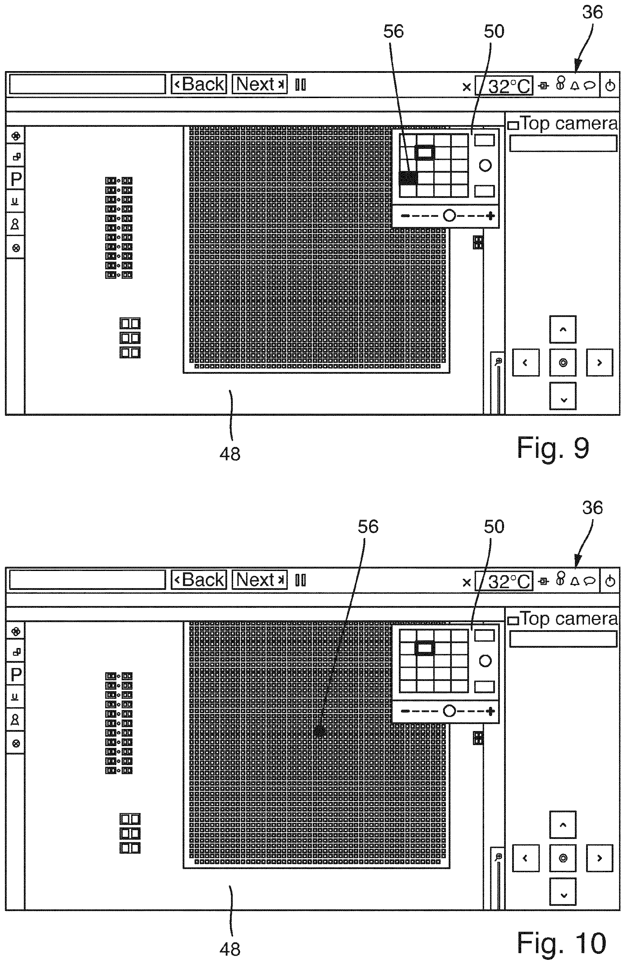

Die Recheneinheit 34 ist weiterhin so eingerichtet, dass beispielsweise nach Erreichen der ersten Solllage der Kamera 44, wie in Figur 8 gezeigt, der Zeiger 56 von der Karte 50 in den Kamerabildbereich 48 bewegt werden kann. Wird der Zeiger 56 über die Karte 50 bewegt, so ändert er wieder seine Kontur in ein ausgefülltes Rechteck, wie es in Figur 9 gezeigt ist. Wird der Zeiger 56 nun weiter aus der Karte 50 in den Kamerabildbereich 48 gezogen, so ändert der Zeiger 56 wiederum seine Kontur; er wechselt erneut zur kreisrunden Kontur, wie es in Figur 10 gezeigt ist. Dadurch wird dem Benutzer signalisiert, dass er nun eine Feinpositionierung vornehmen kann, indem er den Zeiger 56 im Kamerabildbereich 48 an die Position setzt, die er im Kamerabildbereich 48 zentrieren möchte.

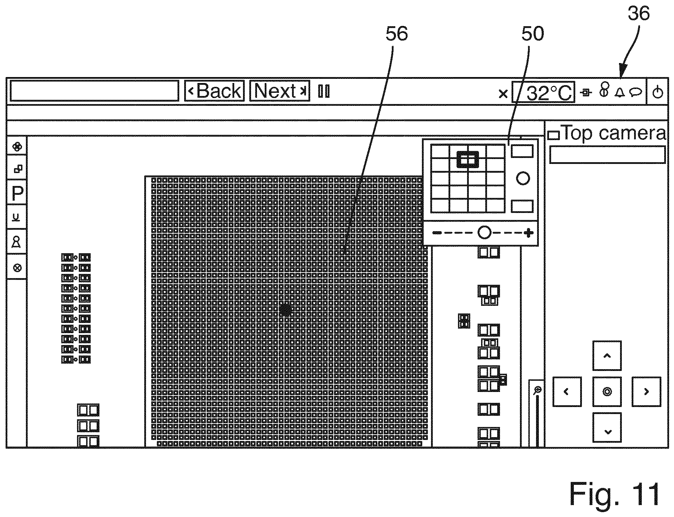

Bewegt der Benutzer nun den Zeiger 56 in Figur 10 an die zweite Sollposition und betätigt dort den Befehlsgeber, dann wird die Antriebseinheit 30 derart angesteuert, dass die Kamera 44 nunmehr in einer der zweiten Sollposition entsprechende zweite Solllage zur Feinpositionierung verfahren wird. Nach Auslösen der Fahrt der Kamera 44 wechselt wiederrum die Form des Zeigers 56 in einen roten Kreis, in dem vorzugsweise ein weißes Quadrat vorhanden ist, was einer Stopp-Taste eines Aufnahmegerätes nachempfunden ist. Das von der Kamera 44 in der zweiten Solllage aufgenommene Kamerabild wird dann, wie es Figur 11 zeigt, mittig im Kamerabildbereich 48 gezeigt.

Die Recheneinheit 34 ist im Positioniermodus derart ausgebildet ist, dass dann, wenn während des Verfahrens der Kamera 44 der Zeiger 56 (der dann insbesondere als roter Kreis mit weißem Quadrat darin dargeboten wird) im Kamerabildbereich 48 oder in der Karte 50 ist und wenn weiter der Befehlsgeber betätigt wird, die Antriebseinheit 30 derart angesteuert wird, dass die Verfahrbewegung gestoppt wird. Hierdurch hat der Benutzer die Möglichkeit die Verfahrbewegung jederzeit durch Betätigen des Befehlsgebers zu stoppen.

Dabei ist das Kamerabild auf die Bewegung der Kamera 44, bzw. auf die Motor- bzw. Verfahrschritte der Antriebseinheit 30 so abgestimmt und ist das System in µm Bereich so kalibriert, dass Längen- oder Abstandsmessungen vorgenommen werden können.

Durch Betätigung von entsprechenden Schaltflächen kann das im Kamerabildbereich 48 gezeigte Kamerabild ggf. weiter vergrößert oder verkleinert werden.

Durch die beschriebene Einrichtung der Recheneinheit kann der Benutzer folglich auf vergleichsweise einfache Art und Weise und vergleichsweise schnell die Kamera an die gewünschte Solllage verfahren, um dort die gewünschte elektronische Komponente in Augenschein zu nehmen.

Vorteilhafterweise weist die Recheneinheit 34 zwei unabhängige Module auf, zum einen ein Modul zur Anzeige des jeweiligen Kamerabilds im Kamerabildbereich 48 zum anderen ein weiteres Modul zur Anzeige der Karte 50 und der jeweiligen Ist-Position 52 der Kamera in der Karte 50. Die Recheneinheit 34 kann dabei den beiden Modulen identische Parameter zur Verfügung zu stellen, so dass die beiden Module synchron zueinander das Kamerabild im Kamerabildbereich 48 und die Karte 50 auf dem Display 36 anzeigen.

## Patentansprüche

1. Reworksystem (10) zum Aus- und/oder Einlöten von elektronischen Komponenten auf einer Leiterplatte (14), mit einem Arbeitstisch (12) zur Befestigung der Leiterplatte (14), mit einer in entlang wenigstens einer X-Achse (18) und einer Y-Achse (20) verfahrbaren Modul (16) mit wenigstens einer Kamera (44, 46) zur Aufnahme von auf der Leiterplatte (14) vorgesehenen elektronischen Komponenten, mit einer Antriebseinheit (30) zum Verfahren des Moduls (16) mit der Kamera (44, 46), mit einer Steuereinheit (32) zur Ansteuerung der Antriebseinheit (30), mit einer Recheneinheit (34), der ein Display (36) und von einem Benutzer bedienbaren Eingabemittel (38) zugeordnet sind, wobei die Eingabemittel (38) einen auf dem Display bewegbaren Zeiger (56) und einen Befehlsgeber umfassen, **dadurch gekennzeichnet, dass** die Recheneinheit (34) derart ausgebildet ist, dass in einem Positioniermodus mit den Eingabemitteln (38) Steuersignale erzeugt werden, in Abhängigkeit derer die Steuereinheit (32) die Antriebseinheit zur Positionierung des Moduls (16) und damit der wenigstens einen Kamera (44, 46) ansteuert, und dass die Recheneinheit (34) weiter derart ausgebildet ist, dass im Positioniermodus
- auf dem Display (36) in einem Kamerabildbereich (48) das Kamerabild der wenigstens einen Kamera (44, 46), das die Leiterplatte (14) und/oder die elektronischen Komponenten der Leiterplatte (14) vergrößert zeigt, und eine den Arbeitstisch (12) und/oder eine am Arbeitstisch (12) befestigte Leiterplatte zeigendes Übersichtsbild (50) gezeigt sind,
- der Zeiger (56) in das Übersichtsbild (50) und dort an eine erste Sollposition der Kamera (44, 46) bewegbar ist,
- bei Betätigen des Befehlsgebers, wenn der Zeiger (56) an der ersten Sollposition in dem Übersichtsbild (50) ist, die Antriebseinheit (30) derart angesteuert wird, dass die Kamera (44, 46) in eine der ersten Sollposition entsprechende erste Solllage verfährt und dass in dieser Solllage das Kamerabild im Kamerabildbereich (48) auf dem Display (36) angezeigt wird,
- nach Erreichen der ersten Solllage der Kamera (44, 46) der Zeiger in den auf dem Display (36) angezeigte Kamerabildbereich (48) an eine zweite Sollposition im angezeigten Kamerabild bewegbar ist, und
- bei Betätigen des Befehlsgebers, wenn der Zeiger an der zweiten Sollposition im Kamerabildbereich (48) ist, die Antriebseinheit (30) derart angesteuert wird, dass die Kamera (44, 46) in eine der zweiten Sollposition entsprechende zweite Solllage verfährt und dass in dieser zweiten Solllage das Kamerabild in einer spezifischen Position im Kamerabildbereich(48) auf dem Display angezeigt wird.

2. Reworksystem (10) nach Anspruch 1, **dadurch gekennzeichnet, dass** die Recheneinheit (34) derart ausgebildet ist, dass von aus einem anderen Modus in den Positioniermodus gewechselt werden kann.

3. Reworksystem (10) nach Anspruch 1 oder 2, **dadurch gekennzeichnet, dass** die Recheneinheit (34) im Positioniermodus derart ausgebildet ist, dass das Kamerabild in der ersten und/oder zweiten Solllage im Kamerabildbereich (48) mittig und insbesondere zentriert angezeigt wird.

4. Reworksystem (10) nach einem der vorhergehenden Ansprüche, **dadurch gekennzeichnet, dass** die Recheneinheit (34) im Positioniermodus derart ausgebildet ist, dass im Übersichtsbild (50) eine der jeweiligen aktuellen Istlage (52) der Kamera (44, 46) entsprechende Istposition angezeigt wird.

5. Reworksystem (10) nach einem der vorhergehenden Ansprüche, **dadurch gekennzeichnet, dass** die Recheneinheit (34) im Positioniermodus derart ausgebildet ist, dass das Kamerabild beim Verfahren der Kamera (44, 46) das während des Verfahrens auf dem Display (36) angezeigt wird.

6. Reworksystem (10) nach einem der vorhergehenden Ansprüche, **dadurch gekennzeichnet, dass** die Recheneinheit (34) im Positioniermodus derart ausgebildet ist, dass dann, wenn während des Verfahrens der Kamera (44, 46) der Zeiger (56) im Kamerabildbereich (48) oder im Übersichtsbild (50) ist und wenn weiter der Befehlsgeber betätigt wird, die Antriebseinheit (32) derart angesteuert wird, das die Verfahrbewegung gestoppt wird.

7. Reworksystem (10) nach einem der vorhergehenden Ansprüche, **dadurch gekennzeichnet, dass** die Recheneinheit (34) im Positioniermodus derart ausgebildet ist, dass das Größenverhältnis des Kamerabildbereichs (48) zum angezeigten Übersichtsbild (50) im Bereich von 40/3 bis 40/1 und weiter im Bereich von 40/2 ist.

8. Reworksystem (10) nach einem der vorhergehenden Ansprüche, **dadurch gekennzeichnet, dass** die Recheneinheit (34) im Positioniermodus derart ausgebildet ist, dass eine Zoomfunktion des Kamerabildes zur Verfügung gestellt wird und dass die Zoomfunktion mittels dem Zeiger und/oder durch Betätigung des Befehlsgebers betätigbar ist.

9. Reworksystem (10) nach einem der vorhergehenden Ansprüche, **dadurch gekennzeichnet, dass** die Recheneinheit (34) im Positioniermodus derart ausgebildet ist, dass der Zeiger (56), wenn er sich im Bereich des Übersichtsbilds (50) befindet, eine andere Kontur aufweist, als wenn der Zeiger (56) sich im Kamerabildbereich (48) befindet.

10. Reworksystem (10) nach einem der vorhergehenden Ansprüche, **dadurch gekennzeichnet, dass** das die Kontur des Zeigers (56) in dem Übersichtsbild als Rechteck ausgebildet ist.

11. Reworksystem (10) nach einem der vorhergehenden Ansprüche, **dadurch gekennzeichnet, dass** die Recheneinheit (34) im Positioniermodus derart ausgebildet ist, dass das Übersichtsbild (50) mittels dem Zeiger (56) und/oder durch Betätigung des Befehlsgebers auf dem Display (36) verschiebbar und/oder minimierbar und/oder maximierbar ist.

12. Reworksystem (10) nach einem der vorhergehenden Ansprüche, **dadurch gekennzeichnet, dass** die Recheneinheit (34) derart ausgebildet ist, dass sie ein erstes Modul ausbildet, das das Übersichtsbild (50) auf dem Display (36) darstellt und dass sie ein zweites Modul ausbildet, das den Kamerabildbereich (48) auf dem Display (36) darstellt, wobei beide Module unabhängig voneinander bereitstellbar oder bereitgestellt sind.
